# EUROPEAN PATENT APPLICATION

(11) **EP 1 416 730 A2**
(43) Date of publication of application: **06.05.2004**
(21) Application number: 04001551.3
(22) Date of filing: 17.10.1996
(51) Int. Cl.: H04N 5/913

(54) **Method and apparatus for locating copy protection signals in a video signal**

(30) Priority: 17.10.1995 US 5681
(62) Divisional of application: 96936734.1
(71) Applicant: Macrovision Corporation, Santa Clara, CA 95050 (US)
(72) Inventor: Quan, Ronald, Cupertino ca 95014 (US)
(74) Representative: Needle, Jacqueline

(57) **Abstract**

In a known copy protection process for preventing recording of video signals, pseudo sync and AGC pulses (Fig. 2) are present on predetermined lines within the blanking intervals of the video signal so that any subsequent video signal shows a picture of very low entertainment quality. The location of the video lines containing the copy protection is determined by using the color burst signal or chroma in the horizontal blanking interval. Then some or all of the lines including copy protection signals may be modified so as to render the overall video signal recordable. In an embodiment, a copy protected video signal is input to a chroma band pass amplifier (16) whose output is applied to a chroma envelope detector (20). The output chroma envelope signal is used to generate a non-retriggerable one shot pulse, and a retriggerable one shot pulse. The retriggerable one shot pulse is applied to a multi line one shot pulse generator (26) to generate a multi line one shot pulse. The non-retriggerable one shot pulse and the multi line one shot pulse are then anded to produce a control signal representing the location of the copy protection pulses.

## Description

The present invention relates to a method and apparatus for locating copy protection signals in a video signal.

US Patent No. 4,631,603 ('603) describes a video signal that is modified so that a television receiver will still provide a normal color picture from the modified video signal whilst a videotape recording of the modified video signal produces generally unacceptable pictures.

The copy protection system described in '603 relies on the fact that a typical video cassette recorder's automatic gain control system cannot distinguish between the normal sync pulses (including equalizing or broad pulses) of a conventional video signal and added pseudo-sync pulses. Pseudo-sync pulses are defined here as pulses which extend down to a normal sync tip level and which have a duration of at least 0.5 microseconds. A plurality of such pseudo-sync pulses is added to the conventional video during the vertical blanking interval, and each of the pseudo-sync pulses is followed by a positive pulse of suitable amplitude and duration. As a result, the automatic gain control system in a videotape recorder will make a fake measurement of video level which causes an improper recording of the video signal. The result is unacceptable picture quality during playback.

US Patent No. 4,819,098 ('098) describes a signal modification which enables a television monitor receiver still to produce a normal picture from the modified signal, whereas a videotape recording of this signal produces generally unacceptable pictures. Videotape recorders have an automatic gain control circuit which measures the sync level in a video signal and develops a gain correction for keeping the video level applied to an FM modulator in the videotape recording system at a fixed, predetermined value. In this system, a plurality of positive pulses are added to a video signal with each immediately following a respective trailing edge of a normally occurring sync pulse. These added pulses are clustered at the vertical blanking interval of each field to minimize the effect of the same on the viewability of the picture defined by the signal while still causing the automatic level control circuit in a recorder to assess the video level at many times its actual value. The sync pulses themselves can also be at a reduced level, in order to enhance the effectiveness of the process.

US Patent No. 4,695,901 ('901) describes the removal of pseudo-sync pulses and AGC pulses that have been added to a video signal to enable acceptable video recording thereof. That is, '901 describes a method of defeating copy protection schemes as set out above. Specifically, '901 discloses the use of a selectively-operable clipping circuit to remove selected negative-value components (i.e. pseudo-sync pulses) from the video signal, while added AGC pulses are effectively blanked from the video signal with an electrically-operated switch. Both the blanking and clipping functions are selectively achieved by sensing both the normal sync pulses of the video signal and the added pseudo-sync pulses.

US Patent No. 4,336,554 ('554) describes a code signal blanking apparatus comprising a switching means operative during a given period of a vertical blanking period of a television signal and a reference level setting means for producing an output of the reference level during said given period when the switching circuit is operative.

US Patent No. 5,194,965 ('965) describes a method and apparatus for disabling the effect of copy-protection signals which is based on differences in the characteristics of television and VCR circuitry. '965 describes a method in which the level of the video signal during the vertical blanking interval is altered, e.g. by level-shifting, so as to render the copy-protect signals ineffective to prevent unauthorized copying by a VCR.

US Patent No. 5,157,510 ('510) also describes a defeat method which utilises differences in the characteristics of television and VCR circuitry. In this method, the effective frequency of the copy-protect signals is increased during the vertical blanking intervals so as to achieve attenuation and/or low pass filtering in the VCR circuitry to thereby render the signals ineffective in preventing copying.

US Patent No. 4,571,615 ('615) discloses a timing signal generator for recovering timing signals in scrambled video signals in which the synchronizing signals are suppressed. The vertical interval is detected as the absence of color burst or chroma in the horizontal blanking interval for a specified time interval, and horizontal sync information is obtained by the detection of the first color burst or chroma in the horizontal blanking interval after an absence of color burst or chroma in the horizontal blanking interval.

All of the defeat methods described in the patents discussed above use vertical and horizontal synchronizing pulses to determine the location of the copy protection signals within a copy protected video signal. There is a need for copy protection defeat mechanisms which do not rely upon the horizontal and vertical synchronizing pulses to determine the location of the copy protection signals.

US-A-4571615 refers to scrambling and descrambling techniques for video signals. It identifies that the detection of color burst following the absence of color burst for a certain interval can be used to identify the occurrence of a vertical interval.

The present invention seeks to provide a method of locating copy protection signals which does not rely upon the horizontal and vertical synchronising pulses to determine the location of the copy protection signals.

According to a first aspect of the present invention there is provided a method of locating copy protection pulses within a copy protected video signal comprising the steps of:
inputting said copy protected video signal;
chroma band passing said video signal;
detecting a chroma envelope;
generating a non-retriggerable one shot pulse;
generating a retriggerable one shot pulse;
using said retriggerable one shot pulse to generate a multi line one shot pulse; and
anding said non-retriggerable one shot pulse and said multi line one shot pulse to produce a control signal representing the location of said copy protection pulses.

The invention also extends to a method of locating copy protection pulses within a copy protected video signal comprising the steps of:
inputting said copy protected video signal;
chroma band passing said video signal;
detecting a chroma envelope;
generating a first one shot pulse;
generating a second one shot pulse; and
anding said second one shot pulse and chroma envelope to produce a control signal representing the location of said copy protection pulses.

According to a further aspect of the present invention there is provided apparatus for locating copy protection pulses within a copy protected video signal comprising;
a chroma band pass amplifier for chroma band passing an input copy protected video signal;
a chroma envelope detector for detecting a chroma envelope;
a non-retriggerable one shot pulse generator for generating a first one shot pulse;
a retriggerable one shot pulse generator for generating a second one shot pulse;
a multi line one shot pulse generator receiving said second one shot pulse and arranged to generate a third one shot pulse; and
an and circuit coupled to receive said first one shot pulse and said third one shot pulse and arranged to produce a control signal representing the location of the copy protection pulses.

The invention also extends to apparatus for locating copy protection pulses within a copy protected video signal comprising;
a chroma band pass amplifier for chroma band passing an input copy protected video signal;
a chroma envelope detector for detecting a chroma envelope;
a first one shot pulse generator for generating a first one shot pulse;
a second one shot pulse generator coupled to receive said first one shot pulse and arranged to generate a second one shot pulse; and
an and circuit coupled to receive said second one shot pulse and a chroma envelope signal output by said chroma envelope detector and arranged to produce a control signal representing the location of the copy protection pulses.

Embodiments of the invention may be used with a copy protection modification circuit "Circuit ACP" which is controlled by the generated control signal.

This "Circuit ACP" eliminates or reduces the effectiveness of the copy protection signals by a) Level shifting and/or pulse narrowing and/or pulse attenuation; b) Normal composite sync replacement; c) Increased normal composite sync size that is larger in amplitude than the pseudo sync such that sync separators will not detect pseudo syncs; and/or d) Replacement of at least part of pseudo AGC locations with a signal (i.e. flat field) such that a recordable copy is possible.

Several different circuits which may be used within "Circuit ACP" are described.

Embodiments of the present invention will hereinafter be described, by way of example, with reference to the accompanying drawings, in which:
Figures 1A, 1B and 1C shows the vertical interval of standard NTSC video signal;
Figure 2 shows a copy protected signal including pseudo sync pulses and AGC pulses;
Figure 3 shows an alternative copy protection signal;
Figure 4 shows a general block diagram of a first embodiment of a location and modification apparatus;
Figure 5 shows a voltage controlled amplifier or modulator embodiment of "Circuit ACP" depicted in Figure 4;
Figure 6 shows a switch to modify copy protection pulses as an alternative arrangement of "Circuit ACP" depicted in Figure 4;
Figure 7 shows a summing amplifier implementation of "Circuit ACP" depicted in Figure 4;
Figure 8 shows a combination of circuits as shown in Figures 5, 6, and 7; and
Figure 9 shows a block diagram of a second embodiment of location and modification apparatus.

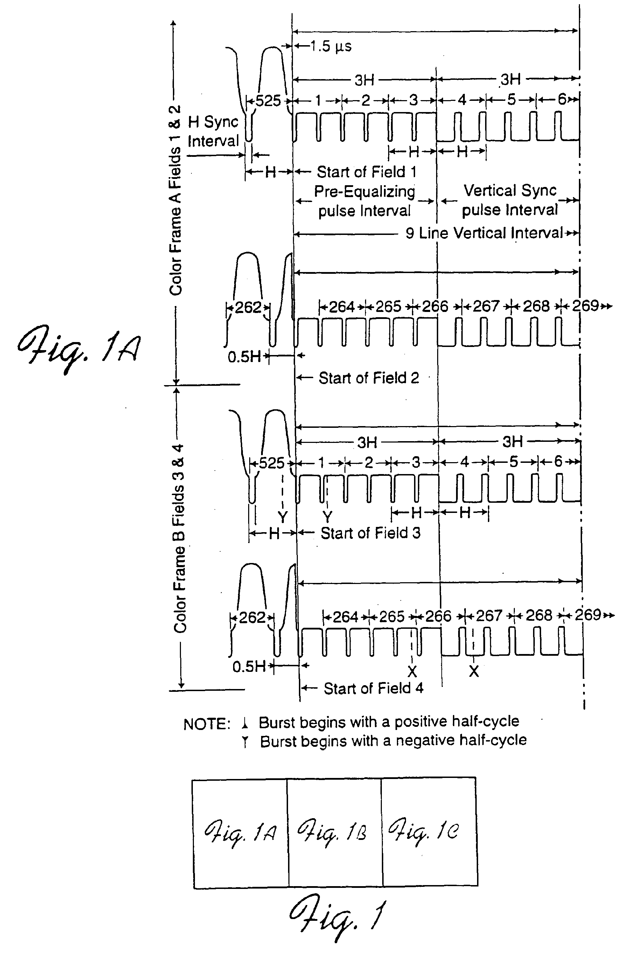

A method of the invention is arranged to locate copy protection signals. When the copy protection signals have been located their effectiveness can be defeated or reduced. Figures 1A, 1B and 1C show the vertical interval of a standard NTSC video signal. Note that the color burst or chroma in the horizontal blanking interval signal is not present during the first nine lines of each field.

There are two basic types of copy protection signals that are commonly present in video signals. The first includes signals in the vertical blanking portion of the video signal. The second which will be discussed below includes copy protection signals in the back porch portion of the video signal.

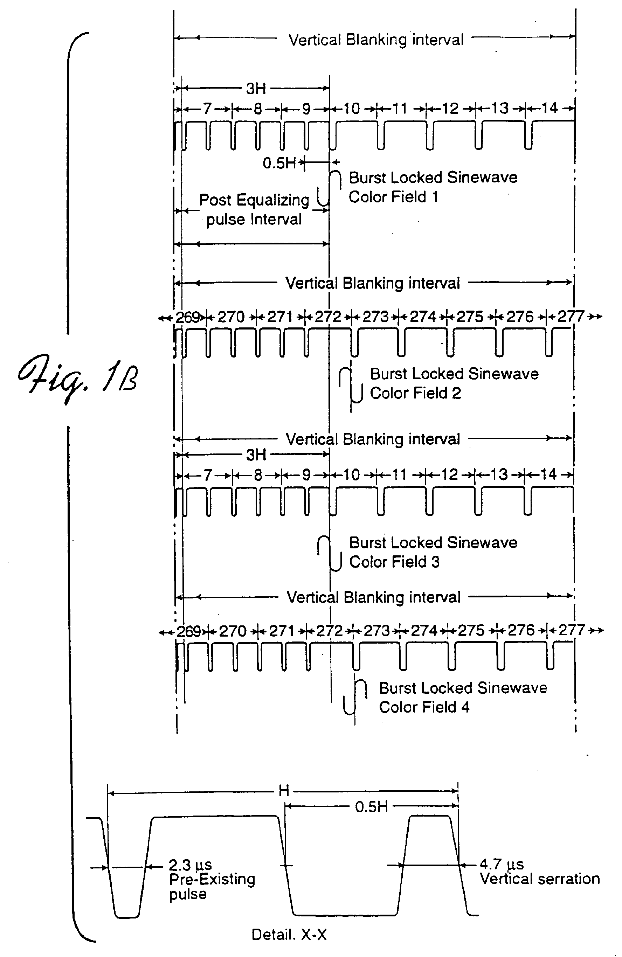

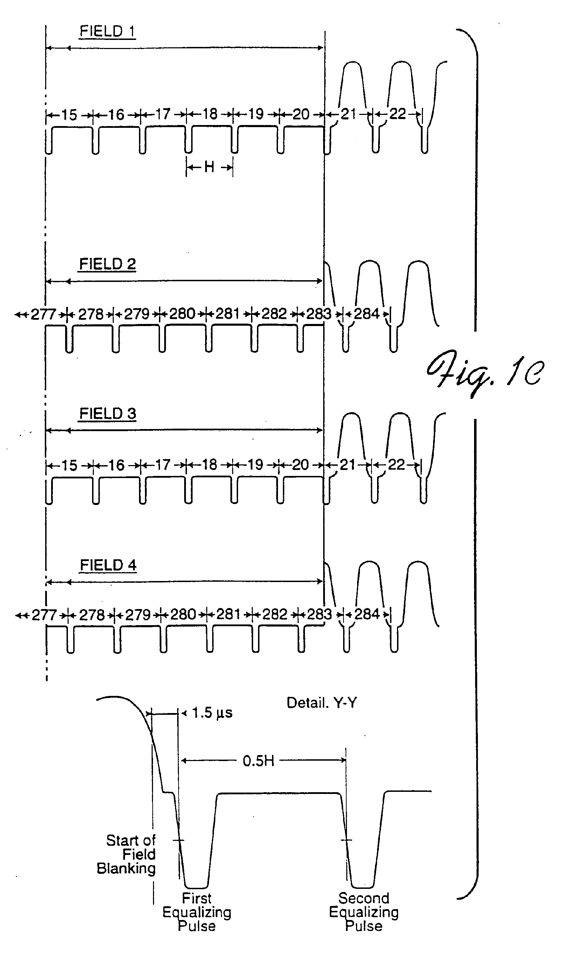

Figure 2 shows one horizontal line within a vertical blanking interval of the copy protection signal including pseudo sync pulses and AGC pulses as described in the '603 patent. The key element of this signal as described in the ' 603 patent is the relationship of the pseudo sync pulse with the AGC pulse. This relationship is the cause of the AGC disturbance in a recorder recording the copy protected signal.

The elements of these copy protection signals are the combination of either a pseudo sync or a regular sync pulse with an AGC pulse. These pairs of sync and AGC pulses are designed to cause the AGC circuitry in a recorder to miscalculate the proper gain setting and thus make an inferior recording. As described below, methods of the invention seek to locate the copy protection signals using the color burst signal. The video signal may then be modified to reduce or eliminate the effects of the copy protection signals.

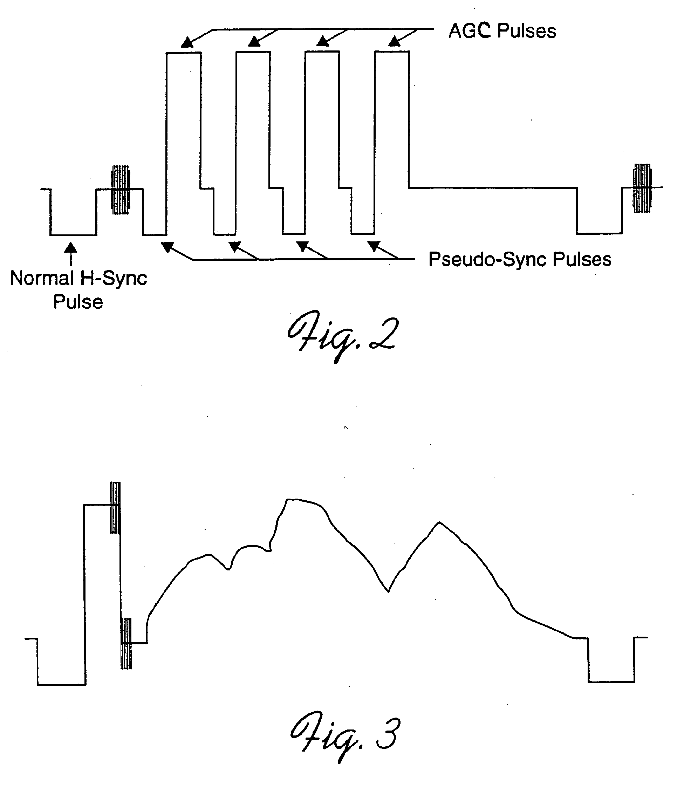

Figure 3 shows a commercial embodiment of a copy protection signal as described in the '098 patent. This signal is placed on several horizontal lines prior to the pre-equalizing pulses of the vertical interval in each field. The combination of these pulses with the pulses in Figure 2 increases the effectiveness of the copy protection without reducing the playability of the signal on a display device.

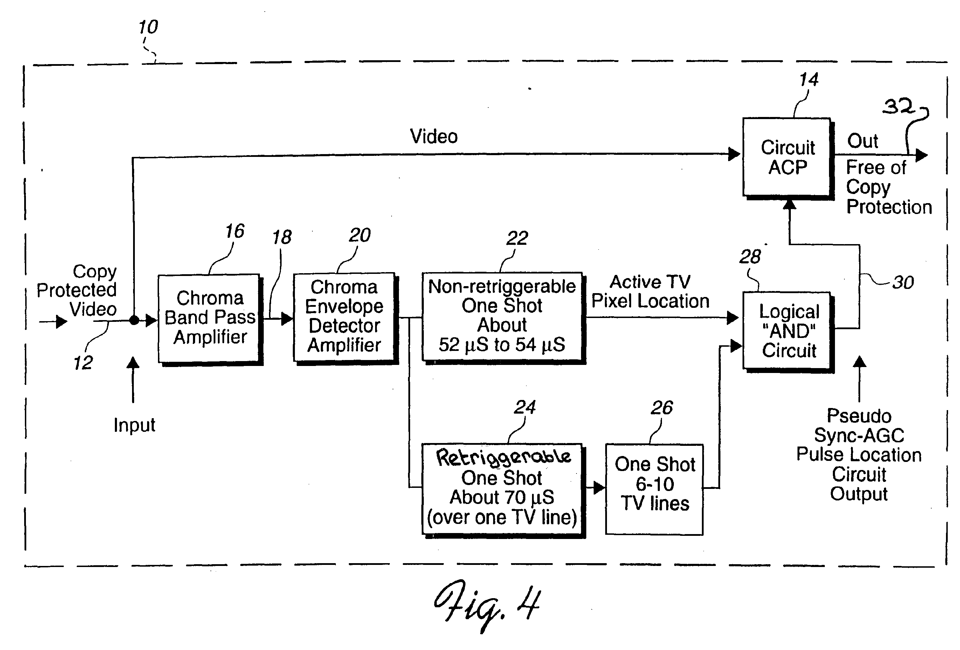

Figure 4 is an over all block diagram of an embodiment of a detection and modification circuit. This embodiment comprises two primary elements. The first of these is a pseudo sync AGC pulse location circuit which differs from detection circuits described in the '901, '965 and '510 patents. The second element is a "Circuit ACP" which modifies the copy protection signal under the control of control pulses generated by the location circuitry.

As discussed above, the vertical and horizontal synchronizing signals within the video signal have previously been utilised to detect the location of copy protection pulses. The methods described herein sense color burst or chroma to detect the copy protection pulses. As noted above, the color burst or chroma in the horizontal blanking interval signal is not present in the first nine lines of each field. The copy protection pulses are in known locations relative to the period containing no color burst or chroma in the horizontal blanking interval signals.

Figure 4 shows a copy protection pulse location and modification circuit which relies on color burst or chroma in the horizontal blanking interval to detect copy protection pulses.

The copy protection pulse location and modification circuit 10 shown in Figure 4 has an input to which a copy protected video signal 12 may be applied. The video signal 12 at the input is applied to a "Circuit ACP" 14 and to a chroma band pass amplifier 16. Chroma band pass amplifier 16 separates the chroma signal from the luminance signal. The chroma signal 18 output from the amplifier 16 is coupled to a chroma envelope detector amplifier 20.

As shown in Figures 1A, 1B and 1C, the color burst or chroma in the horizontal blanking interval signal is missing for about 9 lines in the vertical blanking interval. The circuitry of Figure 4 takes advantage of this. The output of the chroma envelope detector amplifier 20 is coupled to a non-retriggerable one shot 22 (timing circuit) of about 52 microseconds to 54 microseconds (less than one TV line). This ensures that the output of this circuit triggers only burst and not chroma in the active TV line and field. The output of the chroma envelope detector amplifier 20 goes also to a retriggerable one shot 24 (timing circuit) of about 70 microseconds (greater than one line). The interval of the one shot 24 should be greater than 1 TV line but preferably less than 2 TV lines, i.e. less than 126 microseconds. The output of this 70 microsecond one shot is a pulse which is held high from about line 10 to the end of the TV field (and is possibly high for 1 line into the next TV field). Since the AGC pulses and pseudo sync pulses are known to be for lines 10 through 16 or 20, 6-10 TV Line one shot 26 applies the low to high transition of the 70 microsecond one shot 24 into a logical 'AND' circuit 28 to which the output of the 52-54 microsecond one shot 22 (active pixel location) is also applied. The output of the "AND" circuit 28 is a control signal 30 applied to control the 'Circuit ACP' 14 so as to attenuate, clip, blank, level shift, enlarge normal sync pulses relative to pseudo sync pulses, narrow and modify the copy protection pulses sufficiently as to allow a recordable copy into a video tape recorder.

Note the concepts of Figure 4, while in the analog domain, also apply in the digital domain.

As illustrated, the copy protected video signal applied at input 12 of the circuit of Figure 4 is applied to a first input of Circuit ACP 14 to be modified by the Circuit ACP 14. The control signal 30 is applied to a second input of the Circuit ACP 14.

A first embodiment of Circuit ACP 14 uses a voltage controlled amplifier or modulator to increase the gain during the normal composite sync pulses and video outside the VBI but excluding the pseudo syncs. During the pseudo sync and/or AGC pulses the gain can be turned down. This is done by way of the control signal 30.

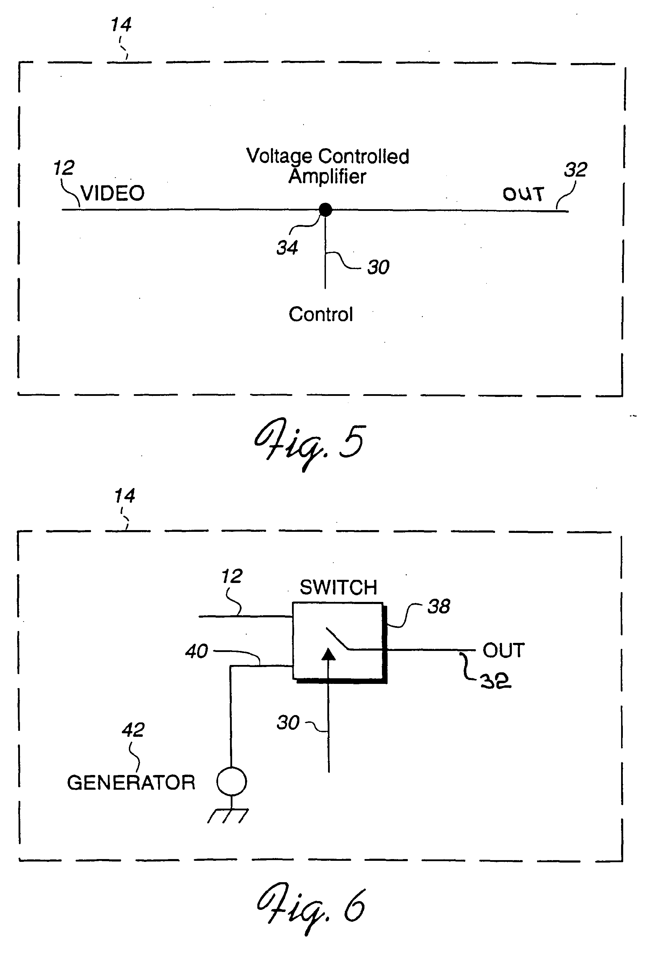

Figure 5 shows an example of a Circuit ACP 14 incorporating a voltage controlled amplifier. The copy protected video signal 12 is applied to an input of voltage controlled amplifier 34, and the control signal 30 is input to the control element of voltage controlled amplifier 34. This produces a voltage controlled output which will perform the various functions described above. The voltage controlled amplifier 34 may be used to change the relative position of the pseudo sync pulses to the normal sync pulses, for example, by level shifting up the pseudo-sync pulses. This prevents the pseudo-sync pulses from being detected. Thus, changing of the relative position of normal sync pulses to the pseudo sync pulses will cause a recorder not to respond to the pseudo sync pulses. In this respect, where the pseudo-sync pulses are shifted up, the recorder responds only to the normal vertical sync pulses since they are the only negative-going pulses sensed relative to the reference level (black voltage level).

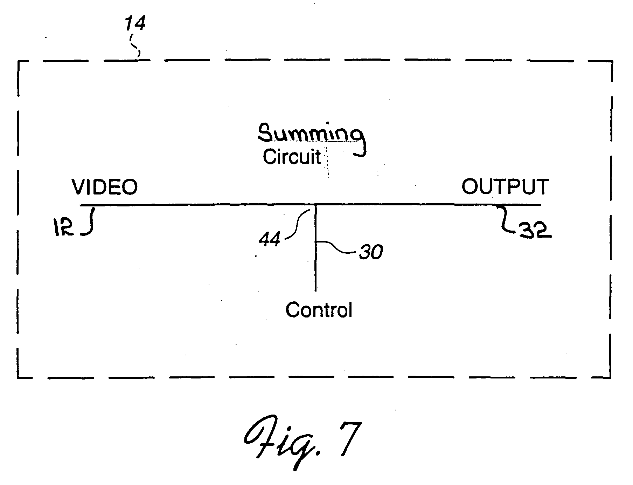

Figure 6 shows another embodiment of Circuit ACP 14 which uses a switch and a signal generator to modify the copy protection added pulses. For instance, if the signal generator produces a signal representing a blanking level, the control signal can be used to replace the added pulses with a signal that allows a recordable copy. The signal generator may be used to generate any signal including random noise or a test signal, or some variations of the input signal may include a modified version (i.e. narrowed pseudo sync pulses or AGC pulses, level shifted copy protection pulses, enlarged sync pulses and/or a filtered version of the copy protection pulses may be used (i.e. bandpass, low pass, high pass) so as to produce distorted copy protection pulses. This signal would replace or modify the copy protection signals so as to allow a recordable copy.

Figure 6 shows Circuit ACP 14 with such a switch generator combination. The copy protected video signal 12 is applied to an input of a switch 38. Control signal 30 is applied to the control element of the switch 38. The second signal input to the switch 38 is a video signal 40 which is generated by a generator 42. By the use of the switch 38 and the generator 42, copy protection pulses within the input video signal 12 are replaced with a blanking level signal or some other signal i.e. modified part or all of copy protection signals or test signal, thus permitting normal recording of the input video signal 12 by a recorder.

A further embodiment of Circuit ACP 14 is illustrated in Figure 7 and uses a summing circuit to level shift the pseudo sync pulses such that the VCR's circuitry does not sense the level shifted pseudo sync pulses. Thus, and as discussed above with reference to Figure 5, a recordable copy can be made. Preferably there is no or little effect during the normal composite sync pulses and video outside the VBI but excluding the pseudo sync pulses. During the pseudo sync and/or AGC pulses the level can be varied. This is done by way of the control signal 30.

Figure 7 illustrates an embodiment of the Circuit ACP 14 with such a summing circuit. A copy protected video signal 12 is applied to an input of a summing circuit 44 and the control signal 30 is input to the control element of the summing circuit 44. The produces a level shift output that will perform the various functions described above. The level shifting signal is used to change the relative position of the pseudo sync pulses to the normal sync pulses such that the AGC system within a recorder will not respond sufficiently to the level shifted pseudo sync pulses.

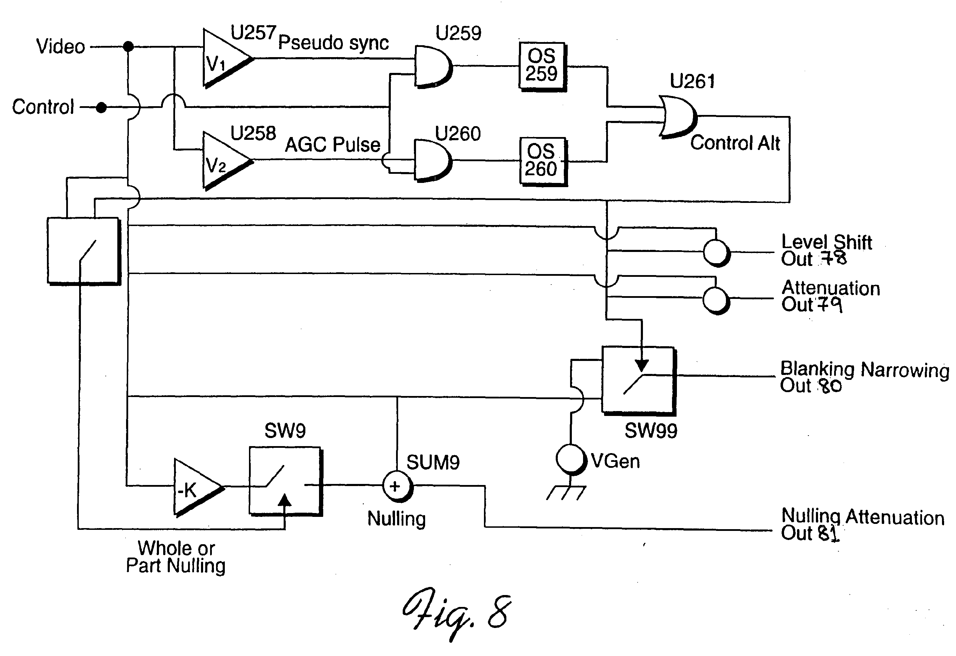

Figure 8 shows a combination of the various Circuit ACP embodiments described above in one package. These include the summing circuit 44, the voltage controlled amplifier 34 and a combination of switch 38 with the voltage generator 42. As described above, the voltage controlled amplifier 34 is arranged to level shift the pseudo-sync pulses and this is achieved by the path in the circuit of Figure 8 having the components U257, U259 and OS259. Similarly, the path in the circuit of Figure 8 having the components U258, U260 and OS260 may be arranged to level shift the AGC pulses. The level shifted pulses are available at output 78. The Control Alt signal generated by OR gate U261 is applied to control switch SW99. This Control Alt control signal is a logic high representing at least a portion of the time when AGC pulses and/or a portion of the time when AGC pulses and/or pseudo sync pulses are on. The output of switch SW99 are narrowed pulses from the voltage generator VGen in combination with the switch SW99. The narrowed pulses are available at output 80. Nulling signals are available at output 81 having been obtained by the attenuation of the video signal input by way of switch SW9 and summing circuit SUM9.

Other "circuit ACP" variations can be circuits that turn logic high by sensing the copy protected video's AGC and pseudo sync pulses. Then timing generators may be used to output pulses shorter in duration than the AGC and pseudo syncs, which in turn is used to narrow the video's AGC pulses and pseudo sync pulses. Of course the copy protection pulses may also be a combination of narrowing, attenuation, level shifting and or modification (i.e. replacement).

The embodiments discussed above have been to locate copy protection signals within the vertical blanking interval and to modify the copy protection signals so as to eliminate them or make them less effective in copy protection.

It is also known to locate copy protection signals on one or more lines within the back porch of a video signal. The methods described herein may similarly be used to eliminate or reduce the effectiveness of these signals.

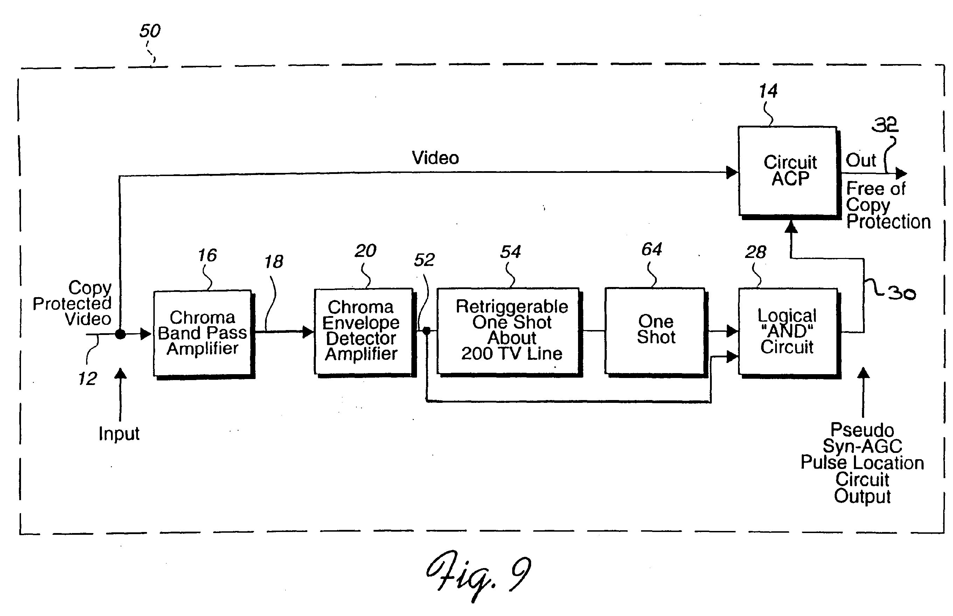

Figure 9 shows a circuit for detecting the position of positive copy protection pulses clustered in the vertical blanking interval.

In a simple case, it would be possible to couple the chroma envelope pulse from the chroma pulse detector directly to Circuit ACP. However, a more reliable method is illustrated in Figure 9 which shows a detection and modification circuit 50. As previously, the circuit 50 senses color burst or chroma in the horizontal blanking interval to detect the copy protection pulses. As noted above, the color burst or chroma in the horizontal blanking interval signal is not present in the first nine lines of each field. The copy protection pulses are in known locations relative to the period containing no color burst or chroma in the horizontal blanking interval signals.

The detection and modification circuit 50 has an input to which a copy protected video signal 12 may be applied. The input video signal 12 is input to a "Circuit ACP" 14 and to a chroma band pass amplifier 16. Chroma band pass amplifier 16 separates the chroma signal from the luminance signal. The band passed chroma signal 18 is coupled to an envelope detector amplifier 20 to generate a chroma envelope pulse. As shown in Figures 1A, 1B and 1C, the color burst or chroma in the horizontal blanking interval signal is missing for about 9 lines in the vertical blanking interval. The circuitry of Figure 9 takes advantage of this.

The output of chroma envelope detector amplifier 20 is coupled to one shot 54 (timing circuit) having a delay time of about 200 to 250 TV lines. A further one shot 64 receives, and is triggered by, one shot 54's output to generate a pulse coincident with the copy protection pulses. These lines are, for example, the last three lines of the field. This ensures that the output of this circuit triggers off the area of the picture known to have copy protection signals within the back porch of the video signal. The width of these pulses can be made adjustable to accommodate variations of copy protection systems that may incorporate copy protection pulses over greater portions of the picture than presently used. The output of the retriggerable one shot 64 and of the chroma envelope detector amplifier 20 are coupled into logical 'AND' circuit 28 which produces back porch AGC pulse pixel to control 'Circuit ACP' so as to attenuate, clip, blank, replace or level shift the copy protection pulses so as to allow a recordable copy into a video tape recorder.

Circuit ACP can be used in this embodiment to level shift the copy protection pulse, limit the bandwidth to pass only chroma, or replace the copy protection pulse with a normal color burst and blanking level.

It should be noted that only a sufficient part of the copy protection signal is needed to be modified to produce a defeat of the copy protection signals. This means only a portion of the pseudo sync and or AGC pulses combined with a sufficient number of added pulse pairs and lines of occurrence.

This disclosure is illustrative and not limiting. All discussion in this specification has referred to the NTSC format. However, it will be appreciated that these techniques are also applicable to the PAL and SECAM formats.

Further modifications and variations may be made to the embodiments described and illustrated within the scope of the appended claims.

## Claims

1. A method of locating copy protection pulses within a copy protected video signal comprising the steps of:
inputting said copy protected video signal;
chroma band passing said video signal;
detecting a chroma envelope;
generating a non-retriggerable one shot pulse; .
generating a retriggerable one shot pulse;
using said retriggerable one shot pulse to generate a multi line one shot pulse; and
anding said non-retriggerable one shot pulse and said multi line one shot pulse to produce a control signal representing the location of said copy protection pulses.

2. A method as claimed in Claim 1, wherein said non-retriggerable one shot pulse has a width less than one line.

3. A method as claimed in Claim 1, wherein said non-retriggerable one shot pulse has a width of 52 to 54 microseconds.

4. A method as claimed in any preceding claim, wherein said retriggerable one shot pulse has a width greater than one line.

5. A method as claimed in any of Claims 1 to 3, wherein said retriggerable one shot pulse has a width of about 70 microseconds.

6. A method as claimed in any preceding claim, wherein said multi line one shot pulse has a width greater than one line.

7. A method as claimed in any of Claims 1 to 5, wherein said multi line one shot pulse has a width of 6 to 10 lines.

8. A method of locating copy protection pulses within a copy protected video signal comprising the steps of:
inputting said copy protected video signal;
chroma band passing said video signal;
detecting a chroma envelope;
generating a first one shot pulse;
generating a second one shot pulse; and
anding said second one shot pulse and chroma envelope to produce a control signal representing the location of said copy protection pulses.

9. A method as claimed in Claim 8, wherein said first one shot pulse has a width of approximately 200 lines.

10. A method as claimed in Claim 8 or 9, wherein said second one shot pulse has a width of approximately 3 TV lines.

11. Apparatus (10) for locating copy protection pulses within a copy protected video signal comprising;
a chroma band pass amplifier (16) for chroma band passing an input copy protected video signal (12);
a chroma envelope detector (20) for detecting a chroma envelope;
a non-retriggerable one shot pulse generator (22) for generating a first one shot pulse;
a retriggerable one shot pulse generator (24) for generating a second one shot pulse;
a multi line one shot pulse generator (26) receiving said second one shot pulse and arranged to generate a third one shot pulse; and
an and circuit (28) coupled to receive first one shot pulse and said third one shot pulse and arranged to produce a control signal (30) representing the location of the copy protection pulses.

12. Apparatus as claimed in Claim 11, wherein said first one shot pulse has a width less than one line.

13. Apparatus as claimed in Claim 11 or Claim 12, wherein said second one shot pulse has a width less than one line.

14. Apparatus as claimed in Claim 11, wherein said first one shot pulse has a width of 52 to 54 microseconds.

15. Apparatus as claimed in Claim 11 or Claim 14, wherein said second one shot pulse has a width greater than one line.

16. Apparatus as claimed in Claim 11 or Claim 14, wherein said second one shot pulse has a width of about 70 microseconds.

17. Apparatus as claimed in any of Claims 11 to 16, wherein said third one shot pulse has a width greater than one line.

18. Apparatus as claimed in any of Claims 11 to 17, wherein said third one shot pulse has a width of 6 to 10 lines.

19. Apparatus (50) for locating copy protection pulses within a copy protected video signal comprising;
a chroma band pass amplifier (16) for chroma band passing an input copy protected video signal (12);
a chroma envelope detector (20) for detecting a chroma envelope;
a first one shot pulse generator (54) for generating a first one shot pulse;
a second one shot pulse generator (64) coupled to receive said first one shot pulse and arranged to generate a second one shot pulse; and
an and circuit (28) coupled to receive said second one shot pulse and a chroma envelope signal output by said chroma envelope detector (20) and arranged to produce a control signal representing the location of the copy protection pulses.

20. Apparatus as claimed in Claim 19, wherein said first one shot pulse has a width of approximately 200 lines.

21. Apparatus as claimed in Claim 19 or Claim 20, wherein said second one shot pulse has a width of approximately 2.8 microseconds.
